# FASCICULE DE BREVET EUROPEEN

(11) **EP 0 466 592 B1**
(45) Date de publication et mention de la délivrance du brevet: **10.10.2001**
(21) Numéro de dépôt: 91401930.2
(22) Date de dépôt: 10.07.1991
(51) Int. Cl.: H03M 9/00

(54) **Dispositif de sérialisation et de désérialisation de données et système de transmission numérique de données en série en résultant**
Vorrichtung zu Parallelserien und zur Serienparallelwandlung von Daten und dadurch entstandenes serielles digitales Nachrichtenübertragungssystem
Device for serialisation and deserialisation of data and resulting serial digital transmission system

(30) Priorité: 11.07.1990 FR 9008812
(43) Date de publication de la demande: 15.01.1992
(73) Titulaire: BULL S.A., 78430 Louveciennes (FR)
(72) Inventeur: Marbot, Roland, F-75116 Paris (FR)

(56) Documents cités:
- EP-A- 0 220 802
- EP-A- 0 292 943
- EP-A- 0 313 875
- EP-A- 0 346 896

## Description

L'invention se rapporte à un dispositif de sérialisation et un dispositif de désérialisation de données et au système de transmission numérique de données en série en résultant.

L'invention s'applique en général à toute sérialisation et désérialisation de données et peut s'adapter à tout système de transmission numérique de données en série. Elle est plus particulièrement avantageuse dans des systèmes à haut débit de transmission en série, à plus de 1 Gbps (1 Gigabit par seconde) par exemple. Les systèmes profitant le plus de l'invention sont notamment les systèmes de transmission en réseau, tels que par exemple des réseaux locaux ou des réseaux de télévision numérique, en particulier de vidéophonie. L'application qui servira d'exemple concerne les réseaux de processeurs dans des systèmes informatiques. Le but de cette application est l'interconnexion de processeurs à des mémoires, d'autres processeurs ou à des périphériques externes ou internes.

Un procédé de sérialisation ordinairement utilisé jusqu'à présent consiste à charger un registre à décalage de N bits en parallèle et à le vider en série. Inversement, la désérialisation consiste à charger en série un registre analogue et à le vider en parallèle. Un autre procédé consiste à remplacer le registre à décalage par un multiplexeur à l'émission et un démultiplexeur à la réception. Le multiplexeur et le démultiplexeur sont chacun commandés par un compteur, comme décrit dans le document EP-A-0 313 875. Les deux procédés utilisent un dispositif verrouillé en phase classique couramment appelé PLL (Phase Locked Loop) pour générer l'horloge. Le signal d'horloge commande la sérialisation et la désérialisation à une fréquence double de la fréquence maximale du signal de données. Le doublement s'impose pour commander le compteur, ou les cellules du registre à décalage, sur un front prédéterminé, montant ou descendant, du signal d'horloge. Par exemple, un vidage à 1Gbps requiert une horloge de 1 GHz alors que le train de données ne dépassera pas 500MHz. Cet exemple illustre la limitation du débit maximal des bits en série à cause d'une trop grande fréquence d'horloge. D'autre part, à cette fréquence d'horloge des bits en série doit s'associer une fréquence d'horloge des mots, N ou 2N fois plus lente. Ces deux horloges doivent être synchrones pour assurer la transmission et la récupération correcte des bits. En pratique, le synchronisme est difficile à obtenir de manière fiable pour des fréquences aussi élevées que celle de l'horloge des bits. En conclusion, l'emploi requis d'une fréquence double de celle du débit des bits en série a l'inconvénient de limiter le débit des bits et de recourir à des dispositifs très sophistiqués pour assurer le synchronisme de l'horloge des bits avec l'horloge des mots.

Le document EP-A-0 220 802 décrit un convertisseur série-parallèle utilisant une horloge de fréquence inférieure au débit des bits. Le convertisseur effectue une désérialisation de mots de N bits en série et comprend un générateur de N signaux d'horloge de période T décalés successivement entre eux d'une valeur prédéterminée égale à la demi-période d'un bit, et un circuit de commande connecté à la sortie du générateur pour commander la sortie en parallèle de chaque mot. Cependant, quand le circuit de commande est fait de N bascules recevant N signaux d'horloge, les retards successifs de ces signaux ne peuvent pas être de T/N mais, alternativement, d'un retard 0 et d'un retard T/N. D'autre part, l'enseignement de ce désérialiseur ne conduit pas à l'évidence à un sérialiseur correspondant, non décrit dans ce document.

D'autre part, dans un système de transmission numérique de données les bits sérialisés sont codés pour constituer le signal de transmission. Le codage est couramment celui désigné sous la forme contractée NRZ (Non Retour à Zéro), ou sa variante NRZI (Non Retour à Zéro Inversé) selon laquelle chaque "1" logique est traduit par un front de changement du signal codé et chaque "0" logique maintient le niveau du signal codé. Le codage de chaque bit est effectué ordinairement par une cellule de codage incluant un registre piloté par le signal d'horloge de l'émetteur. Le signal de transmission incorpore les informations d'horloge et de synchronisation des mots dans un système auto-rythmé. Ces informations sont transmises séparément dans un système synchrone. Dans le récepteur, le signal de transmission reçu est remis en forme pour être décodé, puis désérialisé sous la commande du signal d'horloge reçu dans un système synchrone. Le signal d'horloge est récupéré à partir du signal de transmission dans un système auto-rythmé. Le décodage est fait par N registres recevant le signal de transmission et commandés par le signal d'horloge. Dans ces systèmes, les registres d'encodage s'ajoutent au sérialiseur, et les registres de décodage s'ajoutent au désérialiseur. Les circuits électriques intégrés en résultant sont donc complexes et encombrants.

L'invention remédie aussi à cet inconvénient, en faisant jouer aux registres d'encodage le rôle de registres de sérialisation et aux registres de décodage le rôle le registres de désérialisation. Cette possibilité offre l'avantage d'une simplification notable des circuits et d'une plus forte intégration de ces circuits.

Un dispositif conforme à l'invention de sérialisation de mots de N bits est défini par la revendication 1.

Si un codage doit s'ajouter à la sérialisation, le circuit de commande se compose avantageusement des N registres utilisés pour le codage des N bits.

En corollaire, un dispositif de désérialisation de mots de N bits est défini par la revendication 7.

Si un décodage doit s'ajouter à la désérialisation, les N registres sont avantageusement les registres de décodage du signal de transmission en série.

L'invention se rapporte aussi a un système de transmission numérique de données tel que défini par la revendication 12.

Les caractéristiques et avantages de l'invention ressortent clairement de la description qui suit, donnée à titre d'exemple et faite en référence aux dessins annexés.

Dans les dessins :
- la figure 1 illustre sous forme synoptique un système de transmission numérique auto-rythmé conforme à l'invention ;
- les figures 2A et 2B illustrent schématiquement la structure d'un sérialiseur-encodeur conforme à l'invention inclus dans l'émetteur du système de transmission représenté sur la figure 1 ;
- la figure 3 présente les formes d'onde des signaux d'horloge auxiliaire délivrés par le circuit représenté sur la figure 2A et illustre le fonctionnement du circuit représenté sur la figure 2B ;
- les figures 4A et 4B illustrent respectivement la structure générale d'un mot du signal de données et d'un mot du signal de transmission, tandis que les figures 4C et 4D d'une part, et 4E, 4F d'autre part, illustrent respectivement deux exemples numériques relatifs aux mots respectifs ;
- la figure 5 illustre schématiquement le circuit électrique du récupérateur d'horloge inclus dans le récepteur du système de transmission représenté sur la figure 1 ;
- la figure 6 illustre schématiquement le circuit électrique du désérialiseur-décodeur conforme à l'invention et du tampon de sortie inclus dans le récepteur du système de transmission représenté sur la figure 1 ;
- la figure 7 reproduit les figures 4B et 4F et illustre schématiquement le fonctionnement du désérialiseur-décodeur représenté sur la figure 6 ; et
- la figure 8 présente un chronogramme des signaux d'horloge auxiliaire appliqués au désérialiseur-décodeur et au tampon de sortie représentés sur la figure 6 pour en illustrer le fonctionnement.

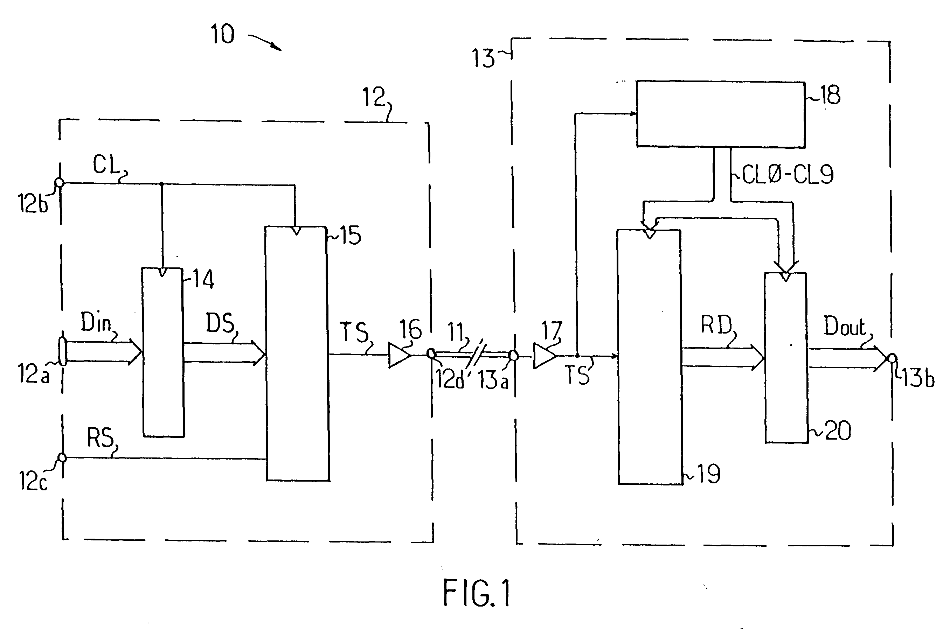

La figure 1 illustre le circuit électrique synoptique d'un système 10 de transmission numérique auto-rythmé conforme à l'invention. Le système 10 comprend une ligne de transmission 11, un émetteur 12 et un récepteur 13. L'émetteur 12 comprend : une borne d'entrée 12a recevant les données parallèles d'un signal d'entrée Din, une borne d'entrée d'horloge 12b recevant un signal d'horloge CL, une borne d'entrée 12c recevant un signal de remise à zéro RS et une borne de sortie 12d connectée à la ligne 11 ; un tampon d'entrée 14 recevant le signal d'entrée Din et piloté par le signal d'horloge CL pour fournir un signal de donnée parallèle DS ; un sérialiseur-encodeur 15 recevant le signal d'horloge CL, le signal de donnée parallèle DS et le signal de remise à zéro RS et délivrant un signal de transmission en série TS ; et un amplificateur de sortie 16 appliquant le signal de transmission TS sur la borne de sortie 12d de l'émetteur 12. Le récepteur 13 comprend : une borne d'entrée 13a connectée à la ligne 11 pour recevoir le signal de transmission TS et une borne de sortie 13b fournissant les données parallèles du signal de sortie Dout ; un amplificateur d'entrée 17 connecté à la borne d'entrée 13a et mettant en forme le signal de transmission TS reçu de la ligne 11 ; un récupérateur d'horloge 18 recevant le signal de transmission TS de l'amplificateur 17 pour restituer les signaux d'horloge auxiliaire CL0-CL9 ; un désérialiseur-décodeur 19 recevant le signal de transmission TS et les signaux d'horloge auxiliaire CL0-CL9 et produisant un signal de données parallèles restituées RD ; et un tampon de sortie 20 recevant le signal de données parallèles restituées RD et certains des signaux d'horloge auxiliaire CL0-CL9 et fournissant le signal de sortie de données Dout à la borne de sortie 13b du récepteur 13.

Dans le système 10, le signal d'entrée Din est un octet de bits de données associé au bit de parité. Ce groupe de neuf bits du signal d'entrée constitue un mot de données d'entrée. Le tampon d'entrée 14 est un élément classique, composé par exemple de neuf registres à front recevant respectivement les neuf bits parallèles du mot du signal d'entrée Din et commandés par le signal d'horloge CL. Les amplificateurs 16 et 17 peuvent aussi être des éléments classiques.

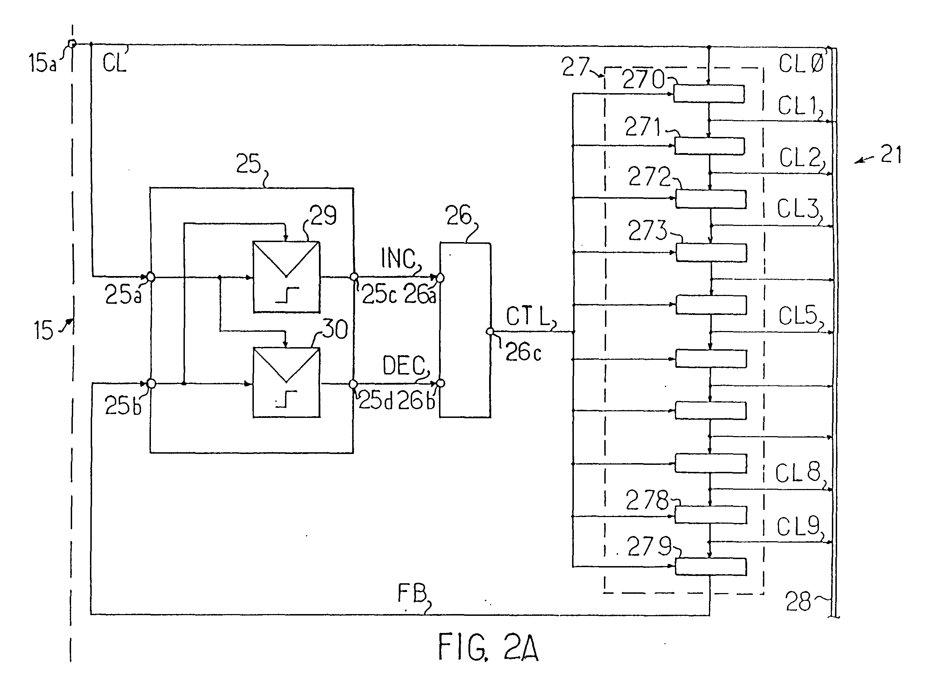

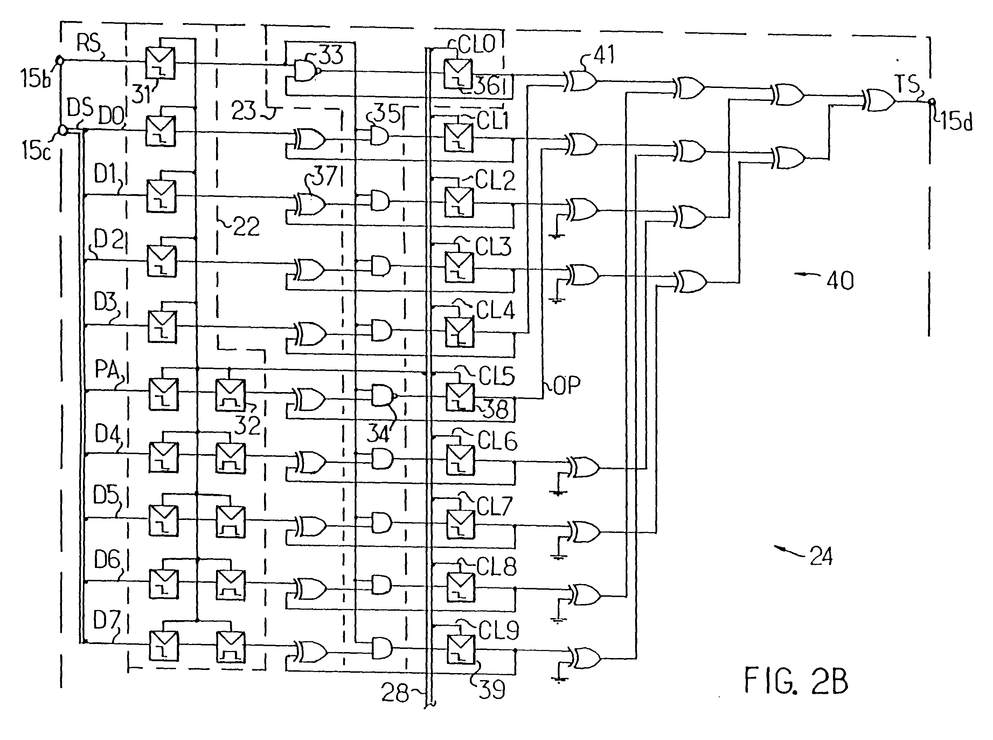

Les figures 2A et 2B illustrent schématiquement le circuit électrique du sérialiseur-encodeur 15. Le sérialiseur-encodeur 15 présente à la figure 2A une entrée 15a recevant le signal d'horloge CL et, à la figure 2B, une entrée 15b recevant le signal de remise à zéro RS, une entrée 15c recevant le signal d'entrée de données DS, et une sortie 15d délivrant le signal de transmission TS. Il se compose d'un générateur d'horloge auxiliaire 21 connecté à l'entrée 15a du sérialiseur-encodeur 15 et représenté sur la figure 2A, d'un bloc tampon 22, d'un générateur de synchronisation 23 et d'un bloc sérialiseur-encodeur 24 représentés sur la figure 2B.

Le générateur d'horloge auxiliaire 21 représenté sur la figure 2A constitue un circuit verrouillé en phase, tel que décrit dans la demande de brevet français de la demanderesse n° 90 01366 du 6 février 1990. Le générateur 21 comprend : la borne d'entrée 15a ; un comparateur de phase 25 ayant une première borne d'entrée 25a connectée à la borne d'entrée 15a, une seconde borne d'entrée 25b et deux bornes de sortie 25c, 25d ; un compteur-décompteur 26 ayant deux bornes d'entrée 26a, 26b connectées respectivement aux bornes de sortie 25c, 25d du comparateur de phase 25 et une borne de sortie 26c ; un circuit à retard de phase 27 composé de dix éléments de retard 270-279 connectés en série entre les deux bornes d'entrée 25a et 25b du comparateur de phase 25 et pourvus chacun d'une borne de commande connectée à la borne de sortie 26c du compteur-décompteur 26 ; et une sortie 28 constituant un bus d'horloge connecté aux bornes de sortie respectives des éléments de retard 270-279.

Le comparateur de phase 25 se compose de deux registres 29 et 30 sensibles aux fronts montants. Le registre 29 a son entrée de données connectée à la borne d'entrée 25a, son entrée d'horloge connectée à la borne d'entrée 25b, et sa sortie connectée à la borne de sortie 25c. Le registre 30 a, de façon similaire, son entrée de données connectée à la borne d'entrée 25b, son entrée d'horloge connectée à la borne d'entrée 25a et sa sortie connectée à la borne de sortie 25d.

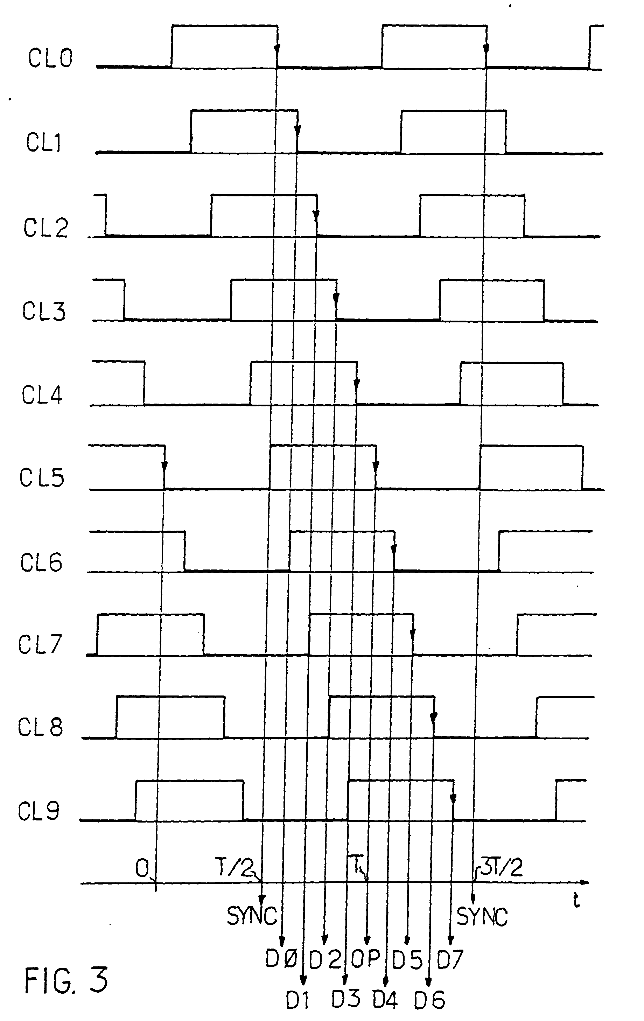

La figure 3 illustre les formes d'onde par rapport à l'axe des temps t des dix signaux d'entrée CL0-CL9 des éléments de retard respectifs 270-279 du circuit à retard de phase 27. Les signaux CL0-CL9 sont appliqués sur le bus d'horloge 28. Le signal CL0 correspond au signal d'horloge CL. Le signal d'horloge CL0 illustré est un signal carré de période T. Le signal de sortie du dernier élément de retard 279 constitue un signal de contre-réaction FB appliqué sur la borne de contre-réaction 25b du comparateur de phase 25. Le comparateur 25 compare donc la phase du signal de contre-réaction FB avec celle du signal d'horloge CL = CL0. Les deux bornes de sortie 25c et 25d du comparateur de phase 25 délivrent respectivement un signal d'incrémentation INC et un signal de décrémentation DEC. En réponse, le compteur-décompteur 12 fournit le signal de commande CTL appliqué sur les bornes de commande respectives des dix éléments de retard 270-279. Chaque élément de retard se compose, de manière classique, d'un nombre prédéterminé de cellules de retard élémentaire. Le signal de commande CTL représente une valeur numérique, qui est appliquée à chaque élément de retard pour en faire varier la durée du retard. La plage de variation possible de la durée du retard d'un élément de retard au cours d'une période T du signal d'horloge CL correspond à une fraction prédéterminée 1/P de l'étendue maximale de la variation de durée d'un élément de retard. En d'autres termes, il faut un nombre entier donné P de périodes T pour passer entre les deux valeurs extrêmes de l'étendue maximale de variation du retard d'un élément.

En fonctionnement, le signal d'horloge CL est retardé successivement par les dix éléments de retard 270-279. Les dix retards successifs produits par les éléments 270-279 sont égaux et divisent en principe la période T du signal d'horloge CL. S'il en est exactement ainsi en pratique, les signaux CL et FB entrant dans le comparateur de phase 25 et appliqués aux registres 29 et 30 ont la même phase et la même fréquence. Les signaux DEC et INC délivrés par les registres 29 et 30 ont donc la même valeur logique. Le compteur-décompteur 26 n'est donc pas activé et laisse le signal de commande CTL inchangé. Les dix signaux d'horloge CL0-CL9 sont correctement déphasés les uns par rapport aux autres d'une même valeur T/10. En pratique, on détermine une marge de tolérance m de déphasage entre le signal d'horloge CL et le signal de contre-réaction FB. Un déphasage dans la marge m laisse les signaux INC et DEC inchangés et n'est donc pas assimilé à un déphasage à corriger. La marge m peut être déterminée par les temps d'établissement des registres 29 et 30 et/ou par des retards relatifs entre les signaux d'entrée de données et d'entrée d'horloge de chaque registre, par exemple. La largeur de la marge m détermine la précision de la comparaison de phase effectuée par le comparateur 25. Elle est typiquement de l'ordre de 50 ps pour une période T = 5 ns du signal d'horloge CL.

Si le signal de contre-réaction FB est en avance de phase sur le signal d'horloge CL, le signal de décrémentation DEC a la valeur logique 0 et le signal d'incrémentation a la valeur 1. Le compteur-décompteur 26 est donc incrémenté pour que le signal de commande CTL augmente de manière égale les durées des retards produits par les éléments 270-279. Au contraire, si le signal de contre-réaction FB est en retard sur le signal d'entrée CL, le signal d'incrémentation INC a la valeur 0 et le signal de décrémentation DEC a la valeur 1. Le compteur-décompteur 26 est décrémenté pour que le signal de commande CTL diminue équitablement les durées des retards produits par les éléments 270-279. Par conséquent, un déphasage au-delà de la marge de tolérance m est corrigé au niveau de tous les éléments de retard 270-279 pour rétablir les déphasages désirés.

La commande de phase numérique mise en oeuvre dans le circuit verrouillé en phase constituant le générateur d'horloge auxiliaire 21 offre un avantage important. Si le signal d'horloge CL est interrompu, par principe le signal de contre-réaction FB est aussi interrompu. Les registres 29 et 30 du comparateur de phase 25 ne reçoivent plus de signal sur leur entrée d'horloge et conservent donc chacun le dernier état de la transmission. De même, le compteur-décompteur 26 conserve son dernier état et, par conséquent, l'état des éléments de retard 270-279. En d'autres termes, le générateur 21 conserve le dernier état de la transmission. Il s'ensuit que la réapparition du premier front du signal d'entrée CL produira immédiatement les signaux de sortie CL0-CL9 corrects si la fréquence du signal d'horloge CL n'a pas changé. Sinon, les retards sont réglés par le compteur-décompteur 26 dès le second cycle du signal d'horloge CL, en vue de produire les signaux de sortie CL0-CL9 désirés. En conclusion, la durée d'établissement du fonctionnement correct du générateur 21 peut être nulle, ou au pire égale au nombre P précité de périodes T du signal d'horloge pour passer entre les deux valeurs extrêmes de l'étendue de variation de la durée de chaque élément de retard. Par conséquent, la mise en marche du générateur 21 ou le réveil d'une ligne de transmission se font très brièvement.

Un second avantage réside dans la large bande de fréquences de fonctionnement du générateur d'horloge auxiliaire 21 . La largeur de la bande dépend essentiellement de la gamme de retards variables de chaque élément de retard 270-279, comme cela ressortira ultérieurement.

Comme autre avantage, le signal d'horloge CL et le signal de contre-réaction FB qui sont comparés par le comparateur de phase 25 ont par principe la même fréquence. La structure du comparateur 25 peut être très simple, comme celle illustrée. En outre, le comparateur peut s'accommoder à une grande bande de fréquences de fonctionnement. En résumé, le générateur d'horloge auxiliaire 21 résout tous les problèmes que posent l'emploi d'un PLL classique. Un autre avantage offert par le générateur 21 réside dans son adaptation aux diverses formes du signal d'horloge CL. Dans l'exemple illustré, le rapport cyclique du signal d'horloge peut être quelconque.

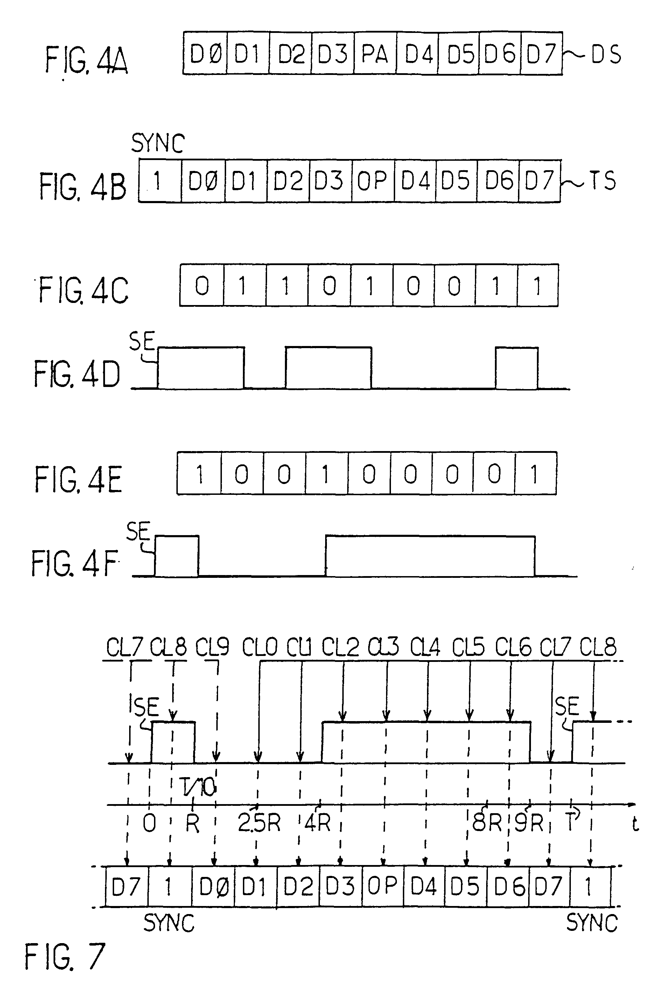

Dans la figure 2B, le bloc tampon 22 du sérialiseur-encodeur 15 est connecté à la borne d'entrée 15b recevant le signal de remise à zéro RS, à la borne d'entrée 15c recevant le signal d'entrée parallèle DS et au bus d'horloge 28 du générateur 21 représenté sur la figure 2A. A titre d'exemple, la figure 4A présente la structure d'un mot du signal d'entrée de données DS appliqué sur la borne 15c du sérialiseur-encodeur 15. Le mot se compose de huit bits de données D0-D7 et d'un bit de parité PA placé entre les bits de données médians D3 et D4. Le bloc tampon 22 se compose de dix registres 31 sensibles aux fronts descendants et de cinq registres de niveau 32, ayant chacun une entrée de données, une entrée d'horloge et une sortie. Tous les registres 31 et 32 ont leur entrée d'horloge recevant le signal d'horloge CL5 du bus d'horloge 28 du générateur d'horloge auxiliaire 21. Les dix registres 31 ont leurs entrées de données recevant respectivement le signal de remise à zéro RS, les quatre premiers bits de données D0-D3, le bit de parité PA et les quatre derniers bits de données D4-D7 du signal d'entrée DS. Les sorties des registres 31 relatifs au bit de parité PA et aux quatre derniers bits de données D4-D7 sont appliquées sur les entrées de signal respectives des registres de niveau 32.

Le générateur de synchronisation 23 inclut deux portes NAND 33, 34 à deux entrées et huit portes AND 35 à deux entrées. Les premières entrées des portes 33, 34 et 35 sont connectées à la sortie du registre 31 relatif au signal de remise à zéro RS. Le générateur 23 comprend en outre un registre à front descendant 36 ayant son entrée d'horloge recevant le signal d'horloge CL0 du bus d'horloge 28, son entrée de données connectée à la sortie de la porte NAND 33 et sa sortie appliquée sur la seconde entrée de la porte NAND 33.

Le bloc sérialiseur-encodeur 24 inclut neuf portes OU Exclusif à deux entrées 37, dont les premières entrées sont connectées aux sorties correspondantes des quatre registres 31 relatifs aux quatre premiers bits de données D0-D3, ainsi qu'aux sorties respectives des cinq registres 32. Les sorties des portes 37 relatives aux bits de données D0-D7 sont respectivement connectées aux secondes entrées des portes AND 35, et la sortie de la porte 37 relative au bit de parité PA est connectée à la seconde entrée de la porte NAND 34. Le bloc sérialiseur-encodeur 24 comporte un registre de parité à front descendant 38 ayant son entrée de données connectée à la sortie de la porte NAND 34 et huit registres de données à front descendant 39 ayant leurs entrées de données respectives connectées aux sorties des portes AND 35. Le registre de parité 38 est commandé par le signal d'horloge CL5 et les huit registres de données 39 sont commandés par les signaux d'horloge CL1-CL9 du bus 28. Les sorties respectives des registres 38 et 39 sont appliquées sur les secondes entrées des portes OU Exclusif 37 correspondantes. Enfin le bloc sérialiseur-encodeur 24 comprend un additionneur logique 40 consistant en un arbre à quatre étages de portes OU Exclusif 41 à deux entrées. Les deux entrées de la première porte 41 du premier étage reçoivent les signaux de sortie respectifs du registre de synchronisation 36 et du registre 39 de la donnée D3. La seconde porte 41 du premier étage reçoit les signaux de sortie respectifs du registre de parité 38 et du registre 39 de donnée D0. Les six autres portes 41 du premier étage ont leurs premières entrées connectées aux sorties des registres 39 des données D1, D2, D4, D5, D6 et D7 et leurs secondes entrées mises à la masse. Les sorties respectives des portes 41 du premier étage relatives au bit de synchronisation et aux bits de données D0-D2 d'une part, et celles relatives aux bits de données D7, D6, D5 et D4 d'autre part, alimentent respectivement les deux entrées des quatre portes 41 du second étage de l'additionneur 40. Les sorties des première et troisième portes 41 du second étage et celles des deux autres portes 41 alimentent respectivement les deux portes 41 du troisième étage, qui alimentent elles-mêmes la porte 41 du dernier étage. La sortie de cette porte délivre le signal de transmission TS à la borne de sortie 15d du sérialiseur-encodeur 15.

Le fonctionnement du sérialiseur-encodeur 15 va maintenant être décrit en référence aux figures 2B, 3 et 4A-4F. Avant l'initialisation du système 10, le signal de remise à zéro RS appliqué sur l'entrée 15b a l'état logique 0, de sorte que les sorties des portes 33, 34 et 35 sont toutes inactivées. Elles sont activées lors de l'initialisation par la mise au niveau logique 1 du signal de remise à zéro RS. On suppose que signal d'horloge CL est appliqué sur l'entrée 15a et que le bus d'horloge 28 fournit les dix signaux d'horloge auxiliaire CL0-CL9 représentés sur la figure 3. Les registres 31 sont commandés à l'instant t = 0 par le front descendant du signal d'horloge CL5 en opposition de phase avec le signal d'horloge CL0. Le signal de remise à zéro RS et les neuf bits du signal d'entrée de données DS représenté sur la figure 4A sont entrés dans les registres 31 respectifs. Dans le générateur de signaux de synchronisation 23, l'état logique 1 de sortie de la porte 33 est mémorisé dans le registre 36 commandé par le front descendant du signal d'horloge CL0. Etant donné que le fonctionnement du système 10 est régi par l'état logique 1 du signal RS, la porte 36 change d'état à chaque front descendant du signal d'horloge CL0.

Les bits de données D0-D3 mémorisés dans les registres 31 respectifs sont transmis aux portes 37 correspondantes. Chaque porte 37 forme avec le registre 39 une cellule élémentaire d'encodage de type NRZI. On a vu que la porte 35 est simplement un élément d'activation du fonctionnement de la cellule. Si par exemple le bit de donnée D0 a l'état logique 1, le front descendant du signal d'horloge CL1 va faire changer l'état logique de sortie du registre 39. Au contraire, si D0 a l'état logique 0, l'état logique du signal de sortie du registre 39 est inchangé par le passage du front descendant du signal d'horloge CL1. La figure 3 illustre la succession des encodages des bits de données D0-D3 correspondant à leur sérialisation au rythme R de T/10.

Cependant, il ressort de la figure 3 que l'encodage du bit de parité PA se produit à l'instant t = T où les registres 31 sont commandés pour mémoriser les bits du mot suivant du signal d'entrée de données DS. Les registres 32 évitent la perte du bit de parité PA et des bits de données D4-D7 du premier mot. Par conséquent, la sérialisation se poursuit par l'encodage du bit de parité PA inversé par la porte NAND 34 pour constituer un bit d'anti-parité OP, puis par l'encodage des bits de données D4-D7. L'encodage et la sérialisation des bits de synchronisation et des données du mot suivant enregistré à l'instant t = 3T/2 se poursuit de la manière qui vient d'être décrite.

Les signaux fournis successivement par les cellules d'encodage sont ajoutés dans l'additionneur 40 pour former le signal de transmission en série TS et l'appliquer à la sortie 15d du sérialiseur-encodeur 15. L'additionneur 40 constitue avec le circuit verrouillé en phase du générateur d'horloge auxiliaire 21 un multiplieur de fréquence d'un facteur égal au nombre de décalages du signal d'horloge CL dans une période, dix dans l'exemple illustré. On trouvera une description plus détaillée d'un tel multiplieur de fréquence dans la demande de brevet français précitée de la demanderesse.

L'invention tire profit de la réalisation en circuits intégrés de l'additionneur logique 40. L'uniformité des caractéristiques des transistors sur un même circuit intégré permet d'égaliser les temps de propagation entre les sorties des signaux d'horloge CL0-CL9 et la sortie 15d de l'additionneur. Ceci assure la formation d'une fréquence multiple de grande qualité.

Le multiplieur de fréquence qui vient d'être décrit profite de tous les avantages du circuit verrouillé en phase 21 et de ceux d'un additionneur logique. On citera notamment la simplicité, la fiabilité et l'adaptation à une large bande de fréquences de fonctionnement. Par exemple, avec un signal d'horloge CL de période T variant entre 5 ns et 10 ns et avec le circuit à retard 27 de dix éléments de retard pouvant produire chacun un retard variant de 500 à 1000 ps, il est possible d'obtenir à la sortie 15d du sérialiseur-encodeur 15 un débit compris entre 1 et 2Gbps.

La figure 4B présente la structure d'un mot du signal de transmission en série TS. Chaque mot du signal TS comprend le mot de données du signal DS, précédé du bit de synchronisation SYNC toujours égal à 1. La figure 4C donne un exemple illustratif d'un mot du signal de données DS, dans lequel le nombre de bits de données de valeur logique 1 est pair et le bit d'antiparité OP a donc la valeur logique 1. Ce mot produit la forme d'onde du signal de transmission TS illustré dans la figure 4D se rapportant à la figure 4B. On remarquera que le bit de synchronisation SYNC se traduit par un front montant qui constitue un front de synchronisation SE dans le signal de transmission TS. La figure 4E présente le cas d'un mot du signal d'entrée de données DS, dans lequel le bit d'antiparité OP a la valeur logique 0 correspondant à un nombre impair de bits de données de valeur logique 1. Il ressort de la figure 4F en référence à la figure 4B que le bit de synchronisation SYNC se traduit encore par un front montant constituant le front de synchronisation SE dans le signal de transmission TS . En résumé, l'addition d'un bit de synchronisation SYNC de valeur logique 1 à chaque mot de données incorporant un bit d'antiparité OP se traduit par un même front de synchronisation SE dans le signal de transmission TS, un front montant dans l'exemple de réalisation illustré.

En résumé, le dispositif conforme à l'invention pour la sérialisation de mots de dix bits qui vient d'être décrit présente les caractéristiques et avantages suivants. Il est commandé par un signal d'horloge CL de période T dix fois plus faible que la période de récurrence R des bits du mot. A partir de ce signal d'horloge sont produits les dix signaux d'horloge auxiliaire CL0-CL9 ayant la même période T que le signal d'horloge CL et retardés successivement de la période T/10. Les dix signaux d'horloge auxiliaire CL0-CL9 commandent la sortie successive des dix bits respectifs de chaque mot. En d'autres termes, chaque bit sort au rythme du signal d'horloge auxiliaire correspondant. La réunion des dix bits sortants de chaque mot se fait au rythme R de T/10 et constitue ainsi le signal de sortie du sérialiseur. Un sérialiseur conforme à l'invention offre le grand avantage de ne traiter que des signaux ayant une basse fréquence et de même valeur. Le signal de sortie à haut débit se forme seulement en sortie du sérialiseur. Il est donc bien adapté à la génération de signaux de très haut débit. De plus, la réalisation du sérialiseur conforme à l'invention est facilitée. L'invention tire aussi judicieusement profit de la réalisation en circuits intégrés du sérialiseur. L'uniformité des caractéristiques des transistors sur un même circuit intégré permet d'avoir simplement des retards identiques dans le générateur de signaux d'horloge auxiliaire et d'égaliser les temps de propagation des signaux dans l'arbre de portes constituant l'additionneur logique 40.

La commande de la sortie des bits par les signaux d'horloge auxiliaire CL0-CL9 est simplement faite par les dix registres 36, 38 et 39. Avantageusement, ces dix registres peuvent servir au codage des bits, comme illustré. Il suffit d'ajouter à chaque registre une porte OU Exclusif 37 pour constituer une cellule de codage en NRZI.

La réalisation d'un sérialiseur conforme à l'invention peut être différente de celle illustrée. En particulier, la description qui précède fait bien ressortir son adaptation à la sérialisation d'un nombre quelconque N de bits dans un mot. Il suffit de générer N signaux d'horloge auxiliaire de période T retardés successivement de la valeur T/N, et de les appliquer sur N registres respectifs.

Dans le récepteur 13 du système 10 conforme à l'invention, le signal de transmission TS reçu sur l'entrée 13a est remis en forme et amplifié dans l'amplificateur 17, puis il est appliqué au récupérateur d'horloge 18 et au désérialiseur-décodeur 19.

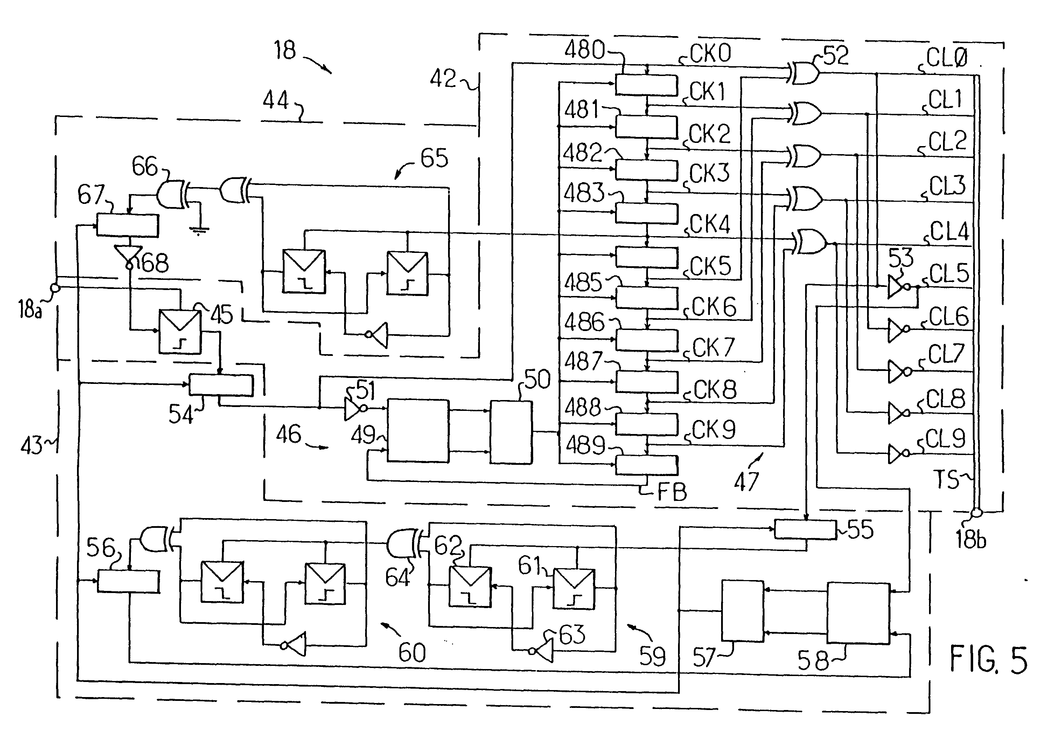

La figure 5 illustre schématiquement le circuit électrique du récupérateur d'horloge 18. Il présente une entrée 18a pour le signal de transmission TS et un bus de sortie 18b des dix signaux d'horloge auxiliaire CL0-CL9 récupérés dans le signal de transmission TS. Il comprend un circuit de récupération d'horloge 42, un circuit de calage d'horloge 43, et un circuit de validation 44.

Le circuit de récupération d'horloge 42 comprend un registre d'entrée 45 à front montant, un circuit verrouillé en phase 46 similaire au générateur d'horloge auxiliaire 21 décrit en référence à la figure 2A, et un additionneur logique 47. Le registre d'entrée 45 reçoit sur son entrée d'horloge le signal de transmission TS. Sa sortie est reliée à l'entrée du circuit verrouillé en phase 46 formé de dix éléments de retard 480-489 en série, d'un comparateur de phase 49, d'un compteur-décompteur 50, tous de structure identique à ceux du circuit 21, et d'un inverseur 51. Les dix signaux d'entrée des éléments de retard respectifs 480-489 constituent des signaux d'horloge intermédiaires CK0-CK9, tandis que le signal de contre-réaction FB issu du dernier élément de retard 489 est appliqué sur l'entrée de contre-réaction du comparateur de phase 49. L'autre entrée du comparateur de phase 49 reçoit par l'intermédiaire de l'inverseur 51 le signal de sortie du registre 45. Les éléments de retard 480-489 sont commandés par le signal de sortie du compteur-décompteur 50 en fonction des signaux d'incrémentation et de décrémentation fournis par le comparateur de phase 49. On verra par la suite que les signaux d'horloge intermédiaires CK0-CK9 ont une fréquence moitié de celle des signaux d'horloge CL0-CL9. L'additionneur logique 47 forme avec le circuit verrouillé en phase 46 un multiplieur de fréquence par deux pour fournir les signaux d'horloge CL0-CL9 sur le bus de sortie 18b du récupérateur d'horloge 18. l'additionneur 47 comprend cinq portes OU Exclusif 52 à deux entrées et cinq inverseurs 53. Les portes 52 ont leurs premières entrées respectives recevant les signaux d'horloge intermédiaires CK0-CK4, leurs secondes entrées respectives recevant les autres signaux CK5-CK9, et leurs sorties respectives délivrant les signaux d'horloge CL0-CL4. Ces cinq signaux d'horloge sont inversés par les cinq inverseurs 53 respectifs pour fournir les cinq autres signaux d'horloge CL5-CL9.

Le circuit de calage d'horloge 43 comprend un premier élément de retard 54 recevant le signal de sortie du registre d'entrée 45 et alimentant l'entrée de l'inverseur 51 et l'entrée du circuit verrouillé en phase 46 qui correspond au signal d'horloge intermédiaire CK0, un second élément de retard 55 recevant le signal d'horloge intermédiaire CK0 et un troisième élément de retard 56. Ces trois éléments de retard ont une structure similaire à celle des éléments de retard 480-489. Leur retard est commandé par le signal de sortie d'un compteur-décompteur 57 en réponse aux signaux d'incrémentation et de décrémentation fournis par un comparateur de phase 58. Le comparateur 58 reçoit le signal d'horloge CL5 et le signal de sortie du troisième élément de retard 56 comme signal de contre-réaction. Le second élément de retard 55 reçoit le signal d'horloge CL0 et fournit un signal de sortie à l'entrée d'une première cellule de retard 59 montée en série avec une seconde cellule de retard identique 60 fournissant le signal d'entrée du troisième élément de retard 56. Chaque cellule de retard 59, 60 se compose d'un registre à front montant 61, d'un registre à front descendant 62, d'un inverseur 63 et d'une porte OU Exclusif de sortie 64 à deux entrées. Le signal de sortie de l'élément de retard 55 est appliqué sur les entrées d'horloge respectives des registres 61 et 62. La sortie du registre 62 est connectée à l'entrée de données du registre 61, dont la sortie est reliée par l'intermédiaire de l'inverseur 63 à l'entrée de données du registre 62. Les signaux de sortie respectifs des registres 61 et 62 sont appliqués aux deux entrées de la porte 64.

Le circuit de validation 44 valide le registre d'entrée 45 du circuit de récupération d'horloge. Il est commandé par le signal d'horloge intermédiaire CK4 et fournit le signal de données du registre d'entrée 45. Il comprend une cellule de retard 65 similaire aux cellules 59 et 60, une porte OU Exclusif 66, un élément de retard 67 et un inverseur 68. Dans la cellule 65, les entrées d'horloge respectives des registres 61 et 62 reçoivent le signal d'horloge intermédiaire CK4 et la porte de sortie 64 délivre un signal appliqué sur une entrée de la porte 66. Cette porte a son autre entrée mise à la masse et sa sortie fournit le signal d'entrée à l'élément de retard 67. L'élément de retard 67 est similaire aux autres et est commandé par le signal de sortie du compteur-décompteur 57 du circuit de calage d'horloge 43 pour fournir le signal de données du registre d'entrée 45 par l'intermédiaire de l'inverseur 68.

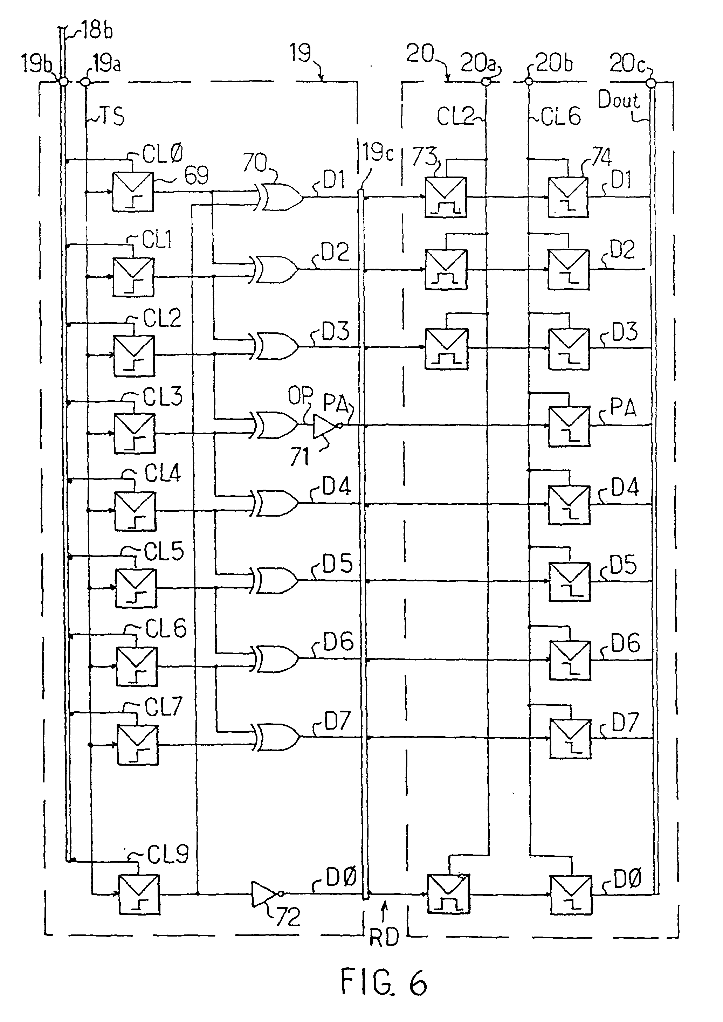

Le désérialiseur-décodeur 19 va maintenant être décrit en référence à la figure 6. Il présente une entrée 19a recevant le signal de transmission TS de l'amplificateur 17, une entrée d'horloge 19b connectée au bus d'horloge 18b issu du récupérateur d'horloge 18, et un bus de sortie 19c fournissant le signal de données récupérées RD. Le désérialiseur-décodeur 19 comprend : un circuit d'échantillonnage composé de neuf registres d'entrée à front montant 69 commandés respectivement par les neuf signaux d'horloge CL0-CL7 et CL9 prélevés du bus 18b et recevant tous le signal de transmission TS ; et un circuit de sortie composé de huit portes OU Exclusif 70 à deux entrées et de deux inverseurs 71, 72. Les deux entrées de chaque porte 70 reçoivent respectivement le signal de sortie du registre 69 correspondant et le signal de sortie du registre 69 précédent. Ainsi, par exemple, la première porte 70 placée en haut de la figure reçoit les signaux de sortie des registres 69 commandés par les signaux d'horloge CL0 et CL9, la seconde porte 70 reçoit ceux des registres 69 commandés par les signaux d'horloge CL1 et CL0,..., et la huitième porte 70 reçoit ceux des registres 69 commandés par les signaux d'horloge CL7 et CL6. La sortie de la quatrième porte 70 est connectée à l'inverseur 71 et celle du registre 69 commandé par le signal d'horloge CL9 est connectée à l'inverseur 72. Les sorties respectives de la première à la dernière porte 70 fournissent les bits de données D1, D2, D3, OP, D4, D5, D6, D7 et la sortie de l'inverseur 72 fournit le bit de donnée D0. Le bit d'antiparité OP est inversé pour constituer le bit de parité PA. Les bits de données et de parité sont appliqués sur le bus de sortie 19c.

La figure 6 illustre aussi schématiquement le circuit électrique du tampon de sortie 20 représenté sur la figure 1. Le tampon de sortie 20 a une entrée de signal connectée au bus 19c, deux entrées d'horloge 20a et 20b recevant respectivement les signaux d'horloge CL2 et CL6, et un bus de sortie 20c délivrant le signal de sortie Dout du récepteur 13 du système 10 conforme à l'invention. Le tampon 20 comprend quatre registres à niveau 73 et neuf registres de sortie à front descendant 74. Les registres à niveau 73 sont commandés par le signal d'horloge CL2 et ont leurs entrées de données recevant respectivement les bits D1-D3 et D0 du bus d'entrée 19c. Les registres de sortie 74 sont commandés par le signal d'horloge CL6. Quatre des registres 74 ont leurs entrées de données respectives connectées aux sorties des quatre registres à niveau 73. Les autres registres 74 ont leurs entrées respectives recevant le bit de parité PA et les bits de données D4-D7 du bus 19c. Les sorties respectives de tous les registres 74 délivrent dans l'ordre indiqué dans la figure 4A les bits de données D0-D7 et le bit de parité PA pour restituer un signal de sortie Dout identique au signal d'entrée DS de l'émetteur 12.

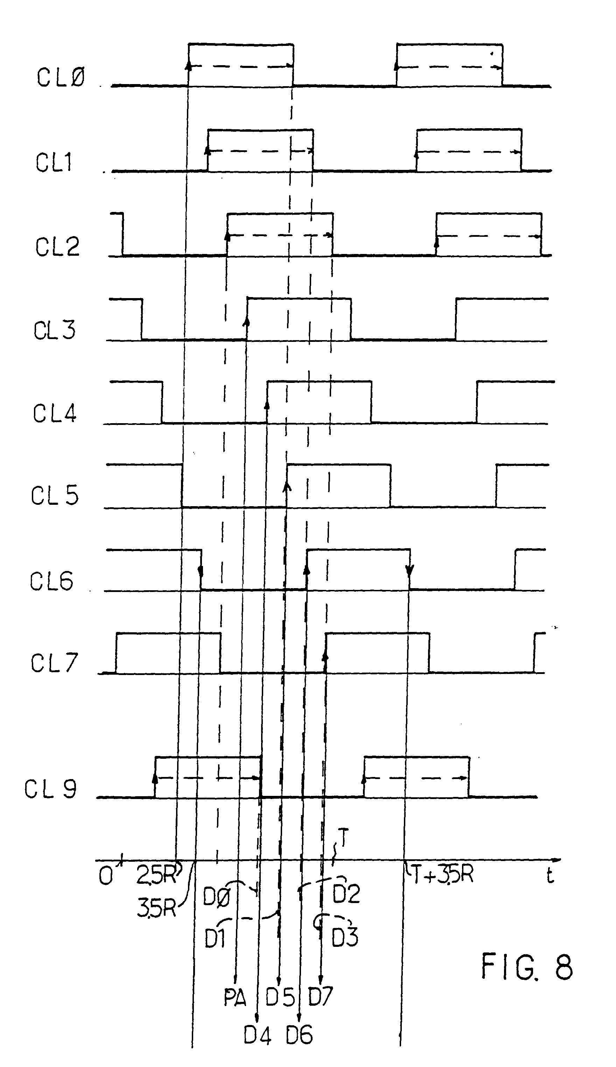

La figure 7 reprend l'exemple de la figure 4E en référence à l'axe des temps t et, pour commodité de lecture, la figure 4B, et illustre schématiquement le fonctionnement du récupérateur d'horloge 18 représenté sur la figure 5. Dans le récupérateur 18, le signal TS est appliqué sur l'entrée d'horloge du registre à front montant 45. Ce registre est supposé validé par le circuit de validation 44 pour être commandé au passage à l'instant t = 0 d'un front de synchronisation SE. Juste après l'instant t = 0 le registre 45 est commandé par le circuit de validation 44 de façon à ne pas réagir aux fronts correspondant aux bits de données et d'antiparité suivants et à ne réagir qu'au prochain front de synchronisation SE à l'instant t = T. La fréquence du signal d'horloge formé par les fronts de synchronisation SE détectés par le registre 45 est donc 1/2T. En d'autres termes, le registre 45 fournit un signal d'horloge intermédiaire CK0 ayant une fréquence moitié de celle du signal d'horloge CL0 émis. Dans le circuit verrouillé en phase 46, les dix éléments de retard 480-489 produisent successivement dix retards identiques partageant la demi-période T du signal d'horloge CK0 et délivrent les dix signaux d'horloge intermédiaires CK0-CK9 et le signal de contre-réaction FB. A cause de la période 2T du signal CK0, celui-ci est en opposition de phase avec le signal de contre-réaction FB et traverse donc l'inverseur 51 pour que ces deux signaux soient en phase aux entrées respectives du comparateur 49. Pour la même raison, l'additionneur logique 47 forme avec le circuit 46 un multiplieur de fréquence par deux afin de délivrer les dix signaux d'horloge CL0-CL9 successivement et uniformément retardés entre eux dans la période T comme ceux générés à l'émission. Dans l'exemple illustré, le front de synchronisation SE détecté par le registre 45 subit un premier retard θ1 en traversant ce registre et un second retard θ2 dans l'élément de retard 54 pour constituer un front du signal d'horloge intermédiaire CK0. Ce dernier front subit un troisième retard θ3 dans la porte 52 pour devenir un front du signal d'horloge auxiliaire CL0.

Il ressort des figures 4D, 4F et 7 que le dernier front montant possible dans le signal TS correspond au bit de données D6 à l'instant t = = 8T/10. Après cet instant, le circuit de validation 44 peut valider l'entrée de signal du registre 45 pour détecter le front montant suivant de synchronisation à l'instant t = T. Dans l'exemple illustré, la validation du registre 45 est faite à l'instant t = 9T/10 = 9R, déterminé par l'accumulation des retards suivants du front de synchronisation SE à partir de l'instant t = 0. Ce front subit d'abord les retards θ1 et θ2 pour constituer un front du signal CK0. En désignant par θ4 la durée d'un retard de chaque élément 480-489, le retard du signal CL4 par rapport au signal CL0 est de 4θ4. Le signal CK4 est choisi comme signal d'entrée du circuit de validation 44. Dans le circuit 44, le signal CK4 traverse, dans la cellule de retard 65, l'un des registres 61 et 62 selon que son front est montant ou descendant et la porte 64, puis la porte OU Exclusif 66, l'élément de retard 67 et l'inverseur 68. En pratique, on supposera que tous les registres présentent des retards identiques θ1 et toutes les portes OU Exclusif présentent des retards identiques θ3, que les inverseurs ne retardent pas les signaux, et que les retards θ2 sont identiques pour les éléments de retard 54 et 67. Les retards cumulés à partir du registre 45 font 9T/10. En d'autres termes, θ1 + θ2 + 4 θ4 + θ1 + 2 θ3 + θ2 = 2 θ1 + 2 θ2 + 2 θ3 + 4 θ4 = 9T/10. A ce point de la description, tous les retards dans cette formule sont connus, à l'exception de θ2 qui va maintenant ressortir de la description du fonctionnement du circuit de calage d'horloge 43 du récupérateur d'horloge 18.

Le circuit 43 synchronise le calage des signaux d'horloge CL0-CL9 à mi-largeur des bits respectifs du signal de transmission TS, à partir de chaque front de synchronisation SE détecté par le registre 45. La mi-largeur R/2 (0,5T/10) du signal représentatif d'un bit correspond en pratique à la plage de stabilité maximale du signal et optimise ainsi la détermination de la valeur logique de chaque bit. Dans l'exemple illustré dans la figure 7, le signal CL0 est calé sur 2,5R = 2,5T/10, de sorte que θ1 + θ2 + θ3 = 2,5T/10. Le retard apporté par l'élément 54 est donc θ2 = 2,5T/10 - θ1 - θ3. La synchronisation du calage du signal d'horloge CL0 est faite par le comparateur de phase 58, qui compare la phase du signal d'horloge CL5 avec celle du signal d'horloge en opposition de phase CL0 retardé successivement dans l'élément de retard 55, les cellules de retard 59 et 60, et dans l'élément de retard 56. Le retard total est donc θ2 + θ1 + θ3 + θ1 + θ3 + θ2 = 2 (θ1 + θ2 + θ3) et doit vérifier l'équation : 2 (θ1 + θ2 + θ3) = 5T/10. Le compteur-décompteur 57 règle la durée de θ2 dans les éléments 54, 55, 56 et 67 pour satisfaire cette équation. Le calage des signaux d'horloge CL0-CL9 est donc réglé sur des retards respectifs 2,5R-11,5R déterminés par rapport à un front de synchronisation SE de façon que chaque signal d'horloge corresponde à la plage de stabilité maximale du signal représentatif du bit correspondant. De plus, le circuit de calage d'horloge règle le retard de 9R du signal de validation du registre 45 par rapport à chaque front de synchronisation détecté par ce registre.

Les figures 7 et 8 illustrent le fonctionnement du désérialiseur-décodeur 19 représenté sur la figure 6. La figure 8 présente les dix signaux d'horloge récupérés CL0-CL9 en référence à l'axe des temps indiqué sur la figure 7 et illustre la récupération des bits de données respectifs en correspondance avec les fronts montants des signaux d'horloge. Dans le désérialiseur-décodeur 19 le signal d'horloge CL8 n'est pas utilisé puisqu'il récupérerait le bit de synchronisation SYNC toujours égal à 1 et inutile dans le signal de données à restituer. Il ressort des figures 6, 7 et 8 que les signaux d'horloge CL0-CL7 et CL9 récupèrent respectivement les bits de données D1-D3, le bit d'antiparité OP et les bits de données D4-D7 et D0. Si pour le mot précédent le signal d'horloge CL9 tracé en tireté dans les figures 7 et 8 échantillonne une valeur logique 0, cette valeur correspond à un front équivalant à un bit de donnée D0 de valeur logique 1. L'inverseur 72 suffit donc pour déterminer la valeur du bit D0. Les autres bits se déterminent en conséquence par les portes OU Exclusif 70 réagissant à la présence d'un front échantillonné par les registres 69 correspondants. Le bit d'antiparité OP ainsi récupéré est inversé en 71 pour restituer le signal de parité PA. Etant donné que le bit D0 est déterminé par le signal d'horloge CL9 du mot précédent, tous les bits du signal de données RD sont à remettre en ordre pour constituer un signal de données identique à celui émis.

La remise en ordre des bits du signal restitué RD est faite dans le tampon de sortie 20 représenté sur la figure 6, de la manière illustrée dans la figure 8. La remise en ordre commence par l'action du signal d'horloge CL2 sur les registres 73. Quand les bits de données D0-D3 sortent du désérialiseur-décodeur 19, le signal CL2 a l'état logique 0 et bloque les registres à niveau 73. A l'instant t = 4,5T/10, le signal d'horloge CL2 prend l'état logique 1 et commande la mémorisation des bits de données D0-D3 dans les registres 73. Pendant ce temps sortent les bits PA et D4-D7. Dans ces conditions, tous les bits D0-D3, PA, D4-D7 du même mot sont présents sur les entrées respectives des registres 74. A l'instant t = T + 3,5T/10, les registres 74 mémorisent ce mot. On notera que les bits de données D0-D3 suivants sont alors déjà échantillonnés mais attendent à l'entrée du tampon de sortie 20 le signal d'horloge CL2 suivant pour entrer.

En résumé, le désérialiseur conforme à l'invention qui vient d'être décrit présente les caractéristiques et avantages suivants. Dix signaux d'horloge auxiliaire CL0-CL9 de période T sont générés par des retards successifs de la valeur T/10. Dans le système de transmission 10 illustré, le récupérateur d'horloge 42 constitue avantageusement le générateur des signaux d'horloge CL0-CL9. Ces signaux d'horloge commandent la sortie en parallèle des bits respectifs de chaque mot. Le désérialiseur présente donc les mêmes avantages que le sérialiseur. En particulier, la sortie en parallèle des bits est simplement faite par des registres commandés par les signaux d'horloge auxiliaire respectifs CL0-CL9. En outre, ces registres peuvent constituer avantageusement des registres de décodage, comme illustré. Normalement, les dix bits devraient être désérialisés. Mais dans l'exemple illustré le bit de synchronisation SYNC est toujours égal à 1 et ne sert pas pour la restitution des données. Neuf registres sont donc utilisés.

De nombreuses variantes peuvent être apportées à l'exemple de réalisation décrit et illustré. En particulier, il ressort à l'évidence que le désérialiseur conforme à l'invention peut facilement s'adapter à la désérialisation d'un nombre quelconque N de bits dans un mot, comme dans le sérialiseur. En outre, parmi les N bits d'un mot, une partie seulement peut être utile pour la restitution de données. Par conséquent, le désérialiseur peut incorporer seulement le nombre de registres correspondant au nombre de bits utiles dans chaque mot.

## Revendications

1. Dispositif de sérialisation (15) de mots de N bits parallèles (D0-D9, OP), comprenant un générateur (21) pour produire simultanément N signaux d'horloge (CL0-CL9) de période T et décalés successivement d'une valeur T/N entre eux, un circuit de commande (36, 38, 39) recevant les N signaux d'horloge et réagissant aux bits de chacun desdits mots pour produire N bits de sortie à un rythme correspondant au décalage des N signaux d'horloge, et des moyens (40) pour disposer en série les N bits de sortie issus de chacun desdits mots de façon à former un signal de bits en série.

2. Dispositif selon la revendication 1, dans lequel le circuit de commande comprend un nombre N de registres (38, 39) recevant respectivement les N bits parallèles et les N signaux d'horloge.

3. Dispositif selon la revendication 2, dans lequel les N registres précités constituent les registres de codage des N bits parallèles respectifs.

4. Dispositif selon la revendication 3, dans lequel une entrée de signal de chaque registre est reliée à la sortie d'une porte OU Exclusif (37) ayant une entrée recevant l'un des N bits parallèles et une autre entrée connectée à la sortie du registre.

5. Dispositif selon l'une des revendications 1 à 4, dans lequel le circuit de commande inclut un bloc tampon (22) de mémorisation des N bits parallèles.

6. Dispositif selon l'une des revendications 1 à 5, dans lequel les moyens (40) pour disposer en série les N bits de sortie comprennent un arbre de portes OU Exclusif (41).

7. Dispositif de désérialisation (19) de mots de N bits en série (D0-D9, OP), comprenant un générateur (42) de N signaux d'horloge (CL0-CL9) de période T décalés successivement d'une valeur prédéterminée entre eux, et un circuit de commande (69) connecté à la sortie du générateur pour commander la sortie en parallèle de chaque mot, **caractérisé en ce que** la valeur prédéterminée est T/N et le circuit de commande réagit à au moins un nombre donné n des N signaux d'horloge pour commander la sortie en parallèle du nombre n de bits respectifs de chacun des mots.

8. Dispositif selon la revendication 7, **caractérisé en ce que** le circuit de commande comprend le nombre n de registres recevant lesdits n bits respectifs de chaque mot et commandés par les n signaux d'horloge respectifs.

9. Dispositif selon la revendication 8, **caractérisé en ce que** les registres constituent des registres de décodage des bits respectifs.

10. Dispositif selon la revendication 8 ou 9, **caractérisé en ce que** le circuit de commande inclut des portes OU Exclusif (70) ayant chacune une entrée connectée à la sortie d'un registre et une autre entrée connectée à la sortie d'un registre précédent.

11. Dispositif selon l'une des revendications 7 à 10, **caractérisé en ce qu'**il comporte des moyens (20) pour mettre le nombre n de bits de sortie parallèle dans le même ordre que celui qui a été émis.

12. Système (10) de transmission numérique de données, comprenant un émetteur (12) utilisant un signal d'horloge (CL) de période T et un signal d'entrée parallèle (DS) et incluant un dispositif de sérialisation (15) et un encodeur pour transmettre un signal de données en série (TS) à une période de transmission R, et un récepteur (13) recevant le signal de données en série (TS) et incluant un récupérateur d'horloge (18) reconstituant le signal d'horloge à partir du signal de données en série, un dispositif de désérialisation (19) et un décodeur pour fournir un signal de sortie parallèle (Dout), **caractérisé en ce que** la période T du signal d'horloge est un multiple N de la période de récurrence R des bits du signal de données en série et **en ce que** le dispositif de sérialisation et le dispositif de désérialisation sont ceux respectivement définis précédemment.

13. Système selon la revendication 12, **caractérisé en ce que** le récupérateur d'horloge constitue le générateur de signaux d'horloge du dispositif de désérialisation.

## Patentansprüche

1. Vorrichtung (15) zum Serialisieren von Wörtern aus N parallelen Bits (D0-D9, OP), mit einem Generator (21) zum gleichzeitigen Erzeugen von N Taktsignalen (CL0-CL9) mit Periode T, die sukzessive um einen Wert T/N zueinander versetzt sind, einer Steuerschaltung (36, 38, 39), die die N Taktsignale empfängt und auf die Bits jedes der Wörter reagiert, um in einem Takt, der der Verschiebung der N Taktsignale entspricht, N Ausgangsbits zu erzeugen, und Mitteln (40) zum seriellen Anordnen der N Ausgangsbits, die von jedem der Wörter stammen, in der Weise, daß ein Signal aus seriellen Bits gebildet wird.

2. Vorrichtung nach Anspruch 1, in der die Steuerschaltung eine Anzahl N von Registern (38, 39) enthält, die die N parallelen Bits und die N Taktsignale empfangen.

3. Vorrichtung nach Anspruch 2, in der die N obengenannten Register die Codierungsregister der jeweiligen parallelen N Bits bilden.

4. Vorrichtung nach Anspruch 3, in der ein Signaleingang jedes Registers mit dem Ausgang eines Exklusiv-ODER-Gatters (37) verbunden ist, das an einem Eingang eines der N parallelen Bits empfängt und mit einem anderen Eingang an den Ausgang des Registers angeschlossen ist.

5. Vorrichtung nach einem der Ansprüche 1 bis 4, in der die Steuerschaltung einen Pufferblock (22) zur Speicherung der N parallelen Bits enthält.

6. Vorrichtung nach einem der Ansprüche 1 bis 5, in der die Mittel (40) zum seriellen Anordnen der N Ausgangsbits einen Baum aus Exklusiv-ODER-Gattern (41) umfassen.

7. Vorrichtung (19) zum Deserialisieren von Wörtern aus N seriellen Bits (D0-D9, OP), mit einem Generator (42) für N Taktsignale (CL0-CL9) mit Periode T, die sukzessive um einen vorgegebenen Wert zueinander versetzt sind, und einer Steuerschaltung (69), die an den Ausgang des Generators angeschlossen ist, um die parallele Ausgabe jedes Wortes zu steuern, **dadurch gekennzeichnet, daß** der vorgegebene Wert T/N ist und die Steuerschaltung wenigstens auf eine gegebene Anzahl n der N Taktsignale reagiert, um die parallele Ausgabe der Anzahl n entsprechender Bits jedes der Wörter zu steuern.

8. Vorrichtung nach Anspruch 7, **dadurch gekennzeichnet, daß** die Steuerschaltung Register in der Anzahl n umfaßt, die die n jeweiligen Bits jedes Wortes empfangen und durch die n jeweiligen Taktsignale gesteuert werden.

9. Vorrichtung nach Anspruch 8, **dadurch gekennzeichnet, daß** die Register Decodierungsregister für die jeweiligen Bits bilden.

10. Vorrichtung nach Anspruch 8 oder 9, **dadurch gekennzeichnet, daß** die Steuerschaltung Exklusiv-ODER-Gatter (70) enthält, wovon jedes mit einem Eingang an den Ausgang eines Registers angeschlossen ist und mit einem anderen Eingang an den Ausgang eines vorhergehenden Registers angeschlossen ist.

11. Vorrichtung nach einem der Ansprüche 7 bis 10, **dadurch gekennzeichnet, daß** sie Mittel (20) umfaßt, die die Anzahl n von Ausgangsbits in der gleichen Reihenfolge wie jene, die ausgegeben worden ist, parallel anordnen.

12. System (10) zur digitalen Übertragung von Daten, mit einem Sender (12), der ein Taktsignal (CL) mit Periode T und ein paralleles Eingangssignal (DS) verwendet und eine Serialisierungsvorrichtung (15) sowie einen Codierer zum Übertragen eines seriellen Datensignals (TS) mit einer Übertragungsperiode R enthält, und einem Empfänger (13), der das serielle Datensignal (TS) empfängt und eine Taktwiedergewinnungseinrichtung (18), die das Taktsignals anhand des seriellen Datensignals wiedergewinnt, eine Deserialisierungsvorrichtung (19) sowie einen Decodierer, der ein paralleles Ausgangssignal (Dout) liefert, enthält,
**dadurch gekennzeichnet, daß** die Periode T des Taktsignals ein Vielfaches N der Wiederholungsperiode R der Bits des seriellen Datensignals ist und daß die Serialisierungsvorrichtung und die Deserialisierungsvorrichtung jene sind, die jeweils oben definiert worden sind.

13. System nach Anspruch 12, **dadurch gekennzeichnet, daß** die Taktwiedergewinnungseinrichtung den Taktsignalgenerator für die Deserialisierungsvorrichtung bildet.

## Claims

1. Device (15) for the serialisation of words of N parallel bits (D0-D9, OP), comprising a generator (21) for simultaneously producing N clock signals (CL0-CL9) with a period T and delayed successively by a value T/N between them, a control circuit (36, 38, 39) receiving the N clock signals and reacting to the bits of each of said words in order to produce N output bits at a rate corresponding to the delaying of the N clock signals, and means (40) for arranging in series the N output bits coming from each of said words so as to form a serial bit signal.

2. Device according to Claim 1, in which the control circuit comprises a number N of registers (38, 39) receiving respectively the N parallel bits and the N clock signals.

3. Device according to Claim 2, in which the N aforementioned registers constitute the encoding registers for the N respective parallel bits.

4. Device according to Claim 3, in which an input signal from each register is connected to the output of an Exclusive OR gate (37) having one input receiving one of the N parallel bits and another input connected to the output of the register.

5. Device according to one of Claims 1 to 4, in which the control circuit includes a buffer block (22) for storing the N parallel bits.

6. Device according to one of Claims 1 to 5, in which the means (40) for arranging in series the N output bits comprise a tree of Exclusive OR gates (41).

7. Device (19) for the de-serialisation of words of N serial bits (D0-D9, OP), comprising a generator (42) of N clock signals (CL0-CL9) with a period T delayed successively by a predetermined value between them, and a control circuit (69) connected to the output of the generator in order to control the parallel output of each word, **characterised in that** the predetermined value is T/N and the control circuit reacts to at least a given number n of the N clock signals in order to control the parallel output of the number n of respective bits of each of the words.

8. Device according to Claim 7, **characterised in that** the control circuit comprises the number n of registers receiving said n respective bits of each word and controlled by the n respective clock signals.

9. Device according to Claim 8, **characterised in that** the registers constitute registers for decoding the respective bits.

10. Device according to Claim 8 or 9, **characterised in that** the control circuit includes Exclusive OR gates (70) each having an input connected to the output of a register and another input connected to the output of a preceding register.

11. Device according to one of Claims 7 to 10, **characterised in that** it comprises means (20) for putting the number n of parallel output bits into the same order as the one that was sent.

12. System (10) for the digital transmission of data, comprising a transmitter (12) using a clock signal (CL) with the period T and a parallel input signal (DS) and including a serialisation device (15) and an encoder for transmitting a serial data signal (TS) at a transmission period R, and a receiver (13) receiving the serial data signal (TS) and including a clock recovery device (18) reconstituting the clock signal on the basis of the serial data signal, a de-serialisation device (19) and a decoder for supplying a parallel output signal (Dout), **characterised in that** the period T of the clock signal is a multiple N of the recurrence period R of the bits of the serial data signal and **in that** the serialisation device and the de-serialisation device are those defined above respectively.

13. System according to Claim 12, **characterised in that** the clock recovery device constitutes the clock signal generator of the de-serialisation device.
